# FASCICULE DE BREVET EUROPEEN

(11) **EP 3 598 450 B1**
(45) Date de publication et mention de la délivrance du brevet: **19.04.2023**
(21) Numéro de dépôt: 19186371.1
(22) Date de dépôt: 15.07.2019
(51) Int. Cl.: G11C 5/14, G11C 7/12, G11C 8/08, G11C 11/418, G11C 11/419, G11C 8/10, G11C 8/16, G11C 11/417

(54) **MEMOIRE SRAM A COURANTS DE FUITE REDUITS**
SRAM-SPEICHER MIT REDUZIERTEN LECKSTRÖMEN
SRAM MEMORY WITH REDUCED LEAKAGE CURRENTS

(30) Priorité: 17.07.2018 FR 1856608
(43) Date de publication de la demande: 22.01.2020
(73) Titulaire: Commissariat à l'énergie atomique et aux énergies alternatives, 75015 Paris (FR)
(72) Inventeur: NOEL, Jean-Philippe, 38054 GRENOBLE CEDEX 09 (FR)
(74) Mandataire: Brevalex

(56) Documents cités:
- US-A1- 2008 089 145
- US-A1- 2016 125 942
- NAVEEN VERMA ET AL: "A 65nm 8T Sub-Vt SRAM Employing Sense-Amplifier Redundancy", IEEE INTERNATIONAL SOLID STATE CIRCUITS CONFERENCE., 1 février 2007 (2007-02-01), pages 328-606, XP055591219, US ISSN: 0193-6530, DOI: 10.1109/ISSCC.2007.373427 ISBN: 978-1-4799-0918-6

## Description

### DOMAINE TECHNIQUE

Le domaine technique de l'invention est celui des mémoires de type SRAM (« Static Random Access Memory », ou mémoire vive statique). L'invention s'applique avantageusement pour la réalisation de circuits asynchrones orientés loT (« Internet of Things », ou Internet des Objets) pour des applications de type « normally OFF / instant ON ».

### ÉTAT DE LA TECHNIQUE ANTÉRIEURE

Les mémoires de type SRAM sont les mémoires embarquées les plus utilisées notamment pour leur vitesse (écriture/lecture) ainsi que pour leur fiabilité (par rapport à des mémoires de type DRAM, « Dynamic Random Access Memory » ou mémoire vive dynamique, ou FLASH).

De plus, contrairement aux autres types de mémoires (DRAM, FLASH, ...), les mémoires SRAM peuvent être utilisées comme mémoires multiports, ce qui veut dire que plusieurs lignes d'une matrice de cellules mémoires, également appelées cellules binaires ou points mémoires, d'une mémoire SRAM peuvent être simultanément activées pour y effectuer des opérations d'écriture et/ou de lecture. Ce mode d'utilisation est très largement répandu, notamment dans les mémoires servant de bancs de registres (« register files ») dans les processeurs, mais également dans certains circuits nécessitant d'avoir des accès asynchrones à la mémoire, c'est-à-dire des accès à des fréquences différentes, comme par exemple les circuits de networking, ou circuits utilisés dans les réseaux de communication.

Pour réaliser un tel circuit mémoire SRAM, chaque cellule mémoire est formée d'une cellule mémoire conventionnelle à 6 transistors (6T-SRAM) à laquelle un ou plusieurs ports de lecture et/ou transistors d'accès supplémentaires pour l'écriture sont ajoutés. Un tel circuit est appelé circuit mémoire *N*R*MW* (où *N* est le nombre d'accès en lecture et *M* le nombre d'accès en écriture dans le même cycle opératoire du circuit) ou *P*RW (où *P* est le nombre d'accès en lecture/écriture dans le même cycle opératoire du circuit). Dans un circuit mémoire *N*R*MW*, les cellules mémoires ont des ports de lecture dédiés alors que dans un circuit mémoire *P*RW, les cellules mémoires ont des ports indissociés pour la lecture et l'écriture. A titre d'exemples, un circuit mémoire SRAM comprenant des cellules mémoires conventionnelles à 6 transistors, ou 6T-SRAM, correspond à un circuit mémoire 1RW, et un circuit mémoire SRAM comprenant des cellules mémoires conventionnelles à 8 transistors dites « dual-port », 8T-DP-SRAM, correspond à un circuit mémoire 2RW.

L'utilisation de transistors d'accès et/ou de ports de lecture supplémentaires dans une cellule SRAM engendre toutefois une augmentation des courants de fuite I_{OFF} de la cellule. Or, dans un circuit mémoire d'un ASIC (« Application-Specific Integrated Circuit », ou circuit intégré propre à une application) ou d'un SoC (« System on Chip », ou système sur puce) dédié au marché de l'IoT où le mode de fonctionnement par défaut correspond au mode veille, la priorité est de limiter le plus possible la consommation électrique en mode veille qui correspond aux courants de fuite I_{OFF} du circuit mémoire. C'est pourquoi l'utilisation de ports de lecture et/ou de transistors d'accès supplémentaires dans les cellules mémoires ne doit pas amener une surconsommation électrique significative par rapport à la partie de la mémoire qui sert uniquement au stockage.

Cette problématique est d'autant plus importante lorsque la cellule SRAM fonctionne avec une tension d'alimentation très faible, par exemple comprise entre environ 0,3 V et 0,4 V. En effet, une baisse de la tension d'alimentation engendre une baisse du courant de conduction I_{ON}, et donc une baisse de la valeur du rapport entre le courant de conduction I_{ON} et les courants de fuite I_{OFF} des transistors de la cellule mémoire, ce qui est problématique pour lire une donnée stockée dans une cellule mémoire sélectionnée en raison de la rapidité avec laquelle le courant de lecture se décharge à travers la ligne de bit (ou BL pour « Bit Line ») à laquelle la cellule mémoire lue est reliée.

Pour limiter l'impact d'un faible rapport I_{ON} / I_{OFF} sur la lecture d'une cellule mémoire dotée d'un port de lecture, il existe deux solutions.

La première solution consiste à limiter le nombre de cellules mémoires par colonne de la mémoire. Ainsi, le courant de fuite global sur chaque colonne, correspondant à la somme des courants de fuite des transistors de chaque cellule mémoire de la colonne, est réduit. Toutefois, avec une très faible tension d'alimentation, ce nombre de cellules mémoires par colonne peut être relativement faible (8, 16 voire 32) pour avoir un rapport I_{ON} / I_{OFF} suffisant permettant une lecture correcte des cellules mémoires, ce qui peut engendrer une perte de surface substantielle liée à l'ajout d'entrées/sorties locales si un grand nombre de colonnes est requis pour compenser le faible nombre de lignes de cellules mémoires.

Une deuxième solution proposée dans les documents N. Verma et al., "A 65nm 8T Sub-Vt SRAM Employing Sense-Amplifier Redundancy", IEEE International Solid-State Circuits Conférence. Digest of Technical Papers, pp. 328-330, 2007, et B. Calhoun et al., "A 256-kb 65-nm Sub-threshold SRAM Design for Ultra-Low-Voltage Operation", IEEE Journal of Solid-State Circuits, Vol. 42, No. 3, Mars 2007, consiste à relier les transistors des ports de lecture de chaque ligne de cellules mémoires non pas à la masse mais à une ligne électrique de masse virtuelle (ou VGND pour « Virtual Ground ») sur laquelle la valeur du potentiel électrique qui est appliquée est contrôlée par un élément de commande, ou driver, qui correspond par exemple à un inverseur. En mode veille ou pour les lignes de cellules mémoires non lues, le potentiel électrique appliqué sur les lignes VGND auxquelles les ports de lectures des cellules mémoires non lues sont reliés a une valeur similaire à celle du potentiel électrique de pré-charge des lignes de bit, égale à celle du potentiel électrique d'alimentation. Il y a donc une différence de potentiels nulle entre les lignes de bit et les lignes VGND auxquelles les ports de lecture des cellules mémoires non lues sont reliés, et donc pas de courants de fuite sous le seuil (qui est le principal courant de fuite d'un transistor) générés dans les transistors de ces ports de lecture. Lorsque qu'une ligne de cellules mémoires est lue, le potentiel électrique de la ligne VGND à laquelle les ports de lecture des cellules mémoires lue sont reliés est mis à 0 V (à la masse) pour permettre la lecture des cellules mémoires. Cette deuxième solution évite une réduction du nombre de cellules mémoires par colonne, ainsi que la perte de surface pouvant en découler.

Néanmoins, cette deuxième solution ne résout que partiellement le problème posé par les courants de fuite car bien que les courants de fuite des ports de lecture soient supprimés, de nouveaux courants de fuite correspondant à ceux des transistors des éléments de commande auxquels les lignes VGND sont reliées viennent s'ajouter.

Dans cette deuxième solution, l'élément de commande de la ligne VGND à laquelle les ports de lecture des cellules mémoires lues sont reliés doit être capable de laisser passer un courant équivalent à *N* × I_{READ}, avec *N* correspondant au nombre de cellules mémoires par ligne, et I_{READ} correspondant au courant de lecture d'une cellule mémoire. Cela a pour conséquence que la taille du transistor de l'élément de commande traversé par ces N courants de lecture doit être relativement conséquente.

Le document N. Verma et al., "A 65nm 8T Sub-Vt SRAM Employing Sense-Amplifier Redundancy", IEEE International Solid-State Circuits Conférence. Digest of Technical Papers, pp. 328-330, 2007 propose de relier les éléments de commande des lignes VGND à un circuit, appelé circuit booster, augmentant temporairement le potentiel électrique appliqué sur la ligne VGND à une valeur supérieure à la tension d'alimentation. Cela autorise de minimiser la taille des transistors des éléments de commande qui sont traversés par les courants de lecture tout en maintenant leur capacité à laisser passer un courant équivalent à *N* × I_{READ}. Néanmoins, cette solution ne reste que partiellement satisfaisante puisque le circuit booster est complexe, encombrant (notamment en raison de la capacité devant être présente dans le circuit booster) et augmente la consommation statique et dynamique de la mémoire. De plus, ce circuit booster ne supprime pas les courants de fuite des transistors des éléments de commande reliés aux lignes VGND. Les documents US2016/125942 A1 et US 2008/089145 A1 divulguent des solutions pour réduire les courants de fuite.

### EXPOSÉ DE L'INVENTION

Un but de la présente invention est de proposer une mémoire SRAM dans laquelle les courants de fuite des ports de lecture sont supprimés, qui ne limite pas le nombre de cellules mémoires par colonne de la mémoire, qui n'engendre pas de perte de surface, et qui réduit les courants de fuite présents globalement dans la mémoire par rapport aux solutions de l'art antérieur.

Pour cela, il est proposé une mémoire SRAM comportant au moins :
- une matrice de cellules mémoires formant des colonnes et des lignes de cellules mémoires ;
- des lignes de bit chacune associée à une des colonnes de cellules mémoires, et des lignes de mot chacune associée à une des lignes de cellules mémoires ;
- des ports de lecture chacun associé à l'une des cellules mémoires et couplé à une des lignes de bit et une des lignes de mot ;
- des lignes de masse virtuelle locale, appelées lignes LVGND (pour « Local Virtual Ground »), chacune couplée à des bornes de potentiel de référence, ou borne de masse, des ports de lecture d'au moins une des lignes de cellules mémoires ;
- des éléments de commande locaux chacun configuré pour coupler électriquement l'une des lignes LVGND à un potentiel électrique d'alimentation appliqué sur une première borne d'alimentation des éléments de commande locaux ou à une ligne de masse virtuelle générale, ou ligne GVGND (pour « Global Virtual Ground »), à laquelle une deuxième borne d'alimentation des éléments de commande locaux est couplée ;
- un élément de commande général configuré pour coupler la ligne GVGND au potentiel électrique d'alimentation ou à un potentiel électrique de référence,
et dans laquelle l'élément de commande général comporte au moins un inverseur comprenant au moins un deuxième transistor PMOS et un deuxième transistor NMOS configurés tels que:
- la source du deuxième transistor PMOS est couplée au potentiel électrique d'alimentation,
- la source du deuxième transistor NMOS est couplée au potentiel électrique de référence,
- les drains des deuxièmes transistors PMOS et NMOS, formant une sortie de l'élément de commande général, sont couplés à la ligne GVGND,
- une entrée de commande de l'élément de commande général est liée aux grilles des deuxièmes transistors NMOS et PMOS de l'élément de commande général.

Ainsi, en mode veille, le potentiel électrique appliqué sur les lignes LVGND par les éléments de commande locaux peut avoir une valeur similaire à celle du potentiel électrique de pré-charge des lignes de bit, égale à celle du potentiel électrique d'alimentation. Il y a donc dans ce cas une différence de potentiels nulle entre les lignes de bit et les lignes LVGND, et donc pas de courants de fuite sous le seuil générés dans les ports de lecture qui sont couplés aux lignes de bit et aux lignes LVGND.

De plus, en mode veille, le potentiel électrique appliqué sur la ligne GVGND par l'élément de commande général peut correspondre au potentiel électrique d'alimentation. Les éléments de commande locaux sont dans ce cas soumis, entre leur potentiel d'alimentation électrique et la ligne GVGND, à une différence de potentiels électriques sensiblement nulle, empêchant également la génération de courants de fuite sous le seuil dans les éléments de commande locaux.

De plus, la solution proposée ici ne limite pas le nombre de cellules mémoires par colonne ni de perte de surface.

Cette mémoire SRAM est avantageusement utilisée avec une tension d'alimentation basse, par exemple comprise entre environ 0,3 V et 0,4 V, puisque la réduction des courants de fuite obtenue permet de conserver un rapport I_{ON} / I_{OFF} suffisant pour lire correctement les données dans les cellules mémoires, et cela même avec un nombre de lignes de cellules mémoires important.

Les lignes de bit correspondent aux lignes à partir desquelles une lecture ou une écriture de données est réalisée dans les cellules mémoires.

Les lignes de mot correspondent aux lignes permettant l'activation des ports de lecture de cellules mémoires destinées à être lues ou écrites.

Le courant de fuite sous le seuil d'un transistor correspond au courant de fuite circulant entre la source et le drain du transistor lorsque celui-ci est à l'état bloqué.

Le courant de fuite de grille d'un transistor correspond au courant de fuite circulant entre la grille et le drain et/ou entre la grille et la source du transistor lorsque celui-ci est à l'état bloqué.

Le mode veille correspond à un état dans lequel la mémoire SRAM est inactive et attend d'être mise dans un état actif, et dans lequel les courants de fuite de la mémoire SRAM sont limités.

Le terme « couplé » désigne ici une liaison pouvant être directe ou indirecte entre les éléments couplés l'un à l'autre.

Le potentiel électrique d'alimentation et le potentiel électrique de référence peuvent être appliqués sur des bornes d'alimentation de l'élément de commande général.

Le potentiel électrique de référence peut correspondre à la masse et avoir une valeur sensiblement nulle, ou le potentiel électrique de référence peut avoir une valeur négative. Lorsque le potentiel électrique de référence a une valeur négative et est appliqué sur la ligne GVGND par exemple lors d'une lecture de cellules mémoires, cela permet d'augmenter la décharge de courant se produisant à travers la ligne GVGND, et donc de gagner en rapidité de fonctionnement.

Chacun des éléments de commande locaux peut comporter au moins un inverseur comprenant au moins un premier transistor PMOS et un premier transistor NMOS configurés tels que :
- la source du premier transistor PMOS (qui forme la première borne d'alimentation de l'élément de commande local) est couplée au potentiel électrique d'alimentation,
- la source du premier transistor NMOS (qui forme la deuxième borne d'alimentation de l'élément de commande local) est couplée à la ligne GVGND,
- les drains des premiers transistors PMOS et NMOS, formant une sortie de l'inverseur de l'élément de commande local, sont couplés à la ligne LVGND associée à l'élément de commande local.

Dans cette configuration, les courants de fuite supprimés dans les éléments de commande locaux grâce à la ligne GVGND correspondent aux courants de fuite sous le seuil des premiers transistors NMOS.

De plus, dans cette configuration, une entrée de commande de chacun des éléments de commande locaux peut être couplée aux grilles des premiers transistors NMOS et PMOS de l'élément de commande local, la mémoire peut comporter en outre un ou plusieurs circuits chacun configuré pour appliquer un potentiel électrique de valeur sensiblement égale au potentiel électrique d'alimentation ou au potentiel électrique de référence sur l'entrée de commande d'un des éléments de commande locaux.

Dans cette configuration, la mémoire peut comporter en outre un ou plusieurs circuits chacun configuré pour appliquer un potentiel électrique de valeur sensiblement égale au potentiel électrique d'alimentation ou au potentiel électrique de référence sur l'entrée de commande de l'élément de commande général.

La mémoire SRAM peut être telle que :
- une entrée de commande de chacun des éléments de commande locaux est couplée aux grilles des premiers transistors NMOS et PMOS de l'élément de commande local ;
- une entrée de commande de l'élément de commande général est couplée aux grilles des deuxièmes transistors NMOS et PMOS de l'élément de commande général ;
et la mémoire peut comporter en outre des circuits chacun configuré pour appliquer un potentiel électrique de valeur sensiblement égale au potentiel électrique d'alimentation ou au potentiel électrique de référence sur l'entrée de commande d'un des éléments de commande locaux ou de l'élément de commande général.

En appliquant, en mode veille, le potentiel électrique d'alimentation sur les grilles des transistors des éléments de commande locaux, les courants de grille des éléments de commande locaux sont supprimés.

Dans cette configuration, chacun des circuits couplés aux entrées de commande des éléments de commande locaux et de l'élément de commande général peut correspondre à un circuit de décalage de niveau configuré pour délivrer en sortie un potentiel électrique de valeur sensiblement égale à celle du potentiel électrique d'alimentation ou de valeur négative.

Dans un mode veille, la mémoire SRAM peut être configurée telle que :
- un potentiel électrique de pré-charge sensiblement égal au potentiel électrique d'alimentation est appliqué sur les lignes de bit,
- les éléments de commande locaux couplent électriquement les lignes LVGND au potentiel électrique d'alimentation, et
- l'élément de commande général couple la ligne GVGND au potentiel électrique d'alimentation.

Dans le mode veille, les circuits couplés aux entrées de commande des éléments de commande locaux peuvent être configurés pour appliquer le potentiel électrique d'alimentation sur les entrées de commande des éléments de commande locaux.

Lorsque les éléments de commande locaux et l'élément de commande général comportent chacun des transistors MOS, les transistors MOS de l'élément de commande général peuvent comporter une tension de seuil supérieure à celle des transistors MOS des éléments de commande locaux.

Lors d'une lecture d'une des lignes de cellules mémoires, la mémoire SRAM peut être configurée telle que :
- l'un des éléments de commande locaux couple la ligne LVGND qui est associée à la ligne de cellules mémoires lue à la ligne GVGND,
- les autres éléments de commande locaux couplent les autres lignes LVGND au potentiel électrique d'alimentation,
- l'élément de commande général couple la ligne GVGND au potentiel électrique de référence.

Les éléments de commande locaux peuvent faire partie d'un décodeur d'adresse de la mémoire SRAM, et l'élément de commande général peut faire partie d'un circuit de contrôle de la mémoire SRAM apte à envoyer des signaux de commande au décodeur d'adresse.

Chaque ligne LVGND peut être couplée aux bornes de potentiel de référence des ports de lecture de deux lignes successives de cellules mémoires.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente schématiquement une mémoire SRAM selon un premier mode de réalisation ;
- la figure 2 représente schématiquement une mémoire SRAM selon un deuxième mode de réalisation ;
- la figure 3 représente schématiquement un exemple de réalisation d'un circuit de décalage de niveau de tension ;
- les figures 4 et 5 représentent des temps de décharge obtenus dans la mémoire SRAM pour différentes configurations.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

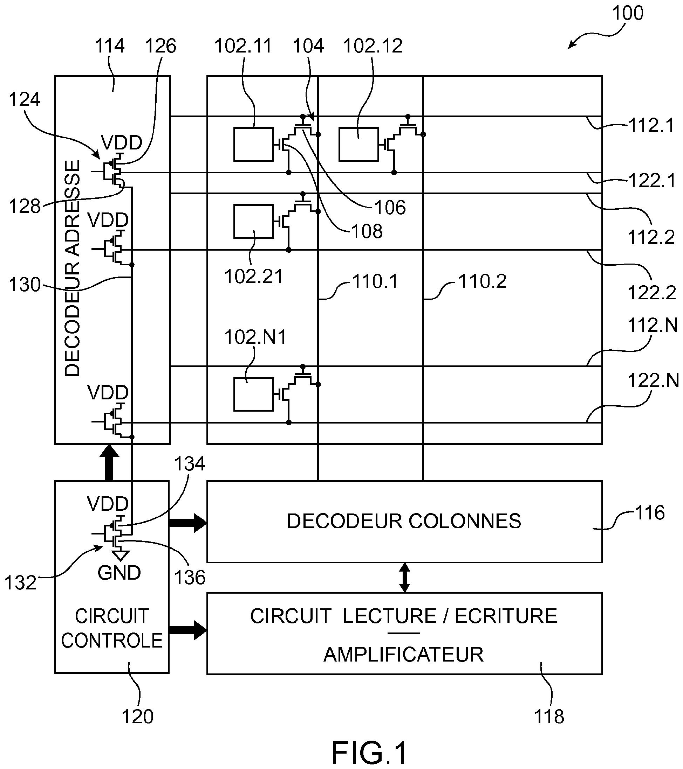

La figure 1 représente schématiquement une mémoire SRAM 100 selon un premier mode de réalisation. Dans la description ci-dessous, seuls les éléments de la mémoire 100 en rapport direct avec l'invention sont décrits en détail.

La mémoire 100 comporte une matrice de *N* lignes et *M* colonnes de cellules mémoires 102, par exemple de type 6T-SRAM. Sur la figure 1, les cellules mémoires 102 sont référencées 102.ij, avec i correspondant au numéro de ligne de la matrice et j correspondant au numéro de colonne de la matrice. Sur la figure 1, seules quatre cellules mémoires 102 sont visibles, à savoir la cellule 102.11 appartenant à la première ligne et à la première colonne de la matrice, la cellule 102.12 appartenant à la première ligne et à la deuxième colonne de la matrice, la cellule 102.21 appartenant à la deuxième ligne et à la première colonne de la matrice, et la cellule 102.N1 appartenant à la *N*^{ème} ligne (dernière ligne) et à la première colonne de la matrice.

Chaque cellule mémoire 102 comporte son noeud de mémorisation couplé à un port de lecture 104. Chaque port de lecture 104 comporte ici un premier transistor MOS 106 comporte une première électrode (source ou drain suivant la conductivité du transistor) relié à une première électrode (source ou drain suivant la conductivité du transistor) d'un deuxième transistor MOS 108. Sur l'exemple de la figure 1, les premier et deuxième transistors MOS 106, 108 sont de type N, la source du premier transistor MOS 106 étant relié au drain du deuxième transistor MOS 108. Le noeud de mémorisation de chaque cellule mémoire 102 est relié à la grille du deuxième transistor MOS 108.

La mémoire 100 comporte également M lignes de bit, ou BL, 110, chacune couplée aux ports de lecture 104 associés aux cellules mémoires 102 d'une des *M* colonnes de la matrice. Sur la figure 1, chaque ligne de bit 110 est reliée à des deuxièmes électrodes des premiers transistors MOS 106 (aux drains des premiers transistors MOS 106 sur l'exemple représenté) des ports de lecture 104 associés aux cellules mémoires 102 d'une des *M* colonnes de la matrice. Sur la figure 1, seules les deux premières lignes de bit 110.1 et 110.2 sont visibles.

La mémoire 100 comporte également *N* lignes de mot, ou WL (pour « Word Line »), 112, chacune couplée aux ports de lecture 104 associés aux cellules mémoires 102 d'une des *N* lignes de la matrice. Sur la figure 1, chaque ligne de mot 112 est reliée aux grilles des premiers transistors MOS 106 des ports de lecture 104 associés aux cellules mémoires 102 d'une des *N* lignes de la matrice. Sur la figure 1, seules les première et deuxième lignes de mot 112.1, 112.2, ainsi que la *N*^{ème} (dernière) ligne de mot 112.N sont visibles.

La mémoire 100 comporte également un décodeur d'adresse 114 auquel les lignes de mot 112 sont couplées et sélectionnant, lors d'une lecture ou d'une écriture dans la mémoire 100, une ligne de cellules mémoires 102 en fonction d'une adresse de ligne reçue en entrée du décodeur d'adresse 114.

La mémoire 100 comporte également un décodeur de colonnes 116 auquel les lignes de bit 110 sont couplées. Lors d'une lecture d'une ligne de cellules mémoires 102, le décodeur de colonnes 116 reçoit, via les lignes de bit 110, des données lues depuis ladite ligne de cellules mémoires 102. Lors d'une écriture dans une ligne de cellules mémoires 102, le décodeur de colonnes 116 envoie sur les lignes de bit 110 les données à écrire dans ladite ligne de cellules mémoires 102. Le décodeur de colonnes 116 est couplé à un circuit de lecture/écriture et d'amplification 118 dont le fonctionnement n'est pas détaillé ici.

La mémoire 100 comporte également un circuit de contrôle 120 assurant notamment la commande du décodeur d'adresse 114, du décodeur de colonnes 116 et du circuit de lecture/écriture et d'amplification 118.

La mémoire 100 comporte également des lignes de masse virtuelle locale, ou LVGND, 122, chacune couplée aux bornes de potentiel de référence, ou bornes de masse, des ports de lecture 104 associés aux cellules mémoires 102 d'au moins une des *N* lignes de la matrice. Sur la figure 1, chaque ligne LVGND 122 est reliée à la deuxième électrode des deuxièmes transistors MOS 108 (aux sources des deuxièmes transistors MOS 108 sur l'exemple représenté) des ports de lecture 104 associés aux cellules mémoires 102 d'une des *N* lignes de la matrice. Sur la figure 1, seules les première et deuxième lignes LVGND 122.1, 122.2, ainsi que la *N*^{ème} (dernière) ligne LVGND 122.N sont visibles. La borne de potentiel de référence d'un port de lecture 104 correspond à la borne du port de lecture 104 qui est, dans une mémoire SRAM non pourvue de ligne de masse virtuelle, reliée à un potentiel de référence correspondant à la masse.

Chacune des lignes LVGND 122 est couplée à un élément de commande local 124 appliquant un potentiel électrique souhaité sur la ligne LVGND 122. Sur l'exemple de la figure 1, chaque élément de commande local 124 correspond à un inverseur formé d'un transistor PMOS 126 et d'un transistor NMOS 128, et dont la sortie est reliée à la ligne LVGND 122 qui lui est associée. Les entrées de commande des éléments de commande locaux 124, correspondant aux grilles des transistors 126, 128, sont par exemple reliées au circuit de contrôle 120 qui commande donc, à travers les éléments de commande locaux 124, les valeurs des potentiels électriques appliqués sur les différentes lignes LVGND 122.

Afin d'empêcher la génération de courants de fuite dans les transistors 106, 108 des ports de lecture 104 vers les éléments de commande locaux 124 à travers les lignes LVGND 122, les éléments de commande locaux 124 ne sont pas alimentés entre un potentiel électrique d'alimentation V_{DD} et un potentiel électrique de référence GND de valeur fixe, mais entre un potentiel électrique d'alimentation V_{DD} (appliqué sur la source du transistor PMOS 126 qui forme une première borne d'alimentation de l'élément de commande local 124) et une ligne de masse virtuelle globale, ou GVGND, 130. Sur l'exemple représenté sur la figure 1, c'est la source du deuxième transistor NMOS 128 (formant une deuxième borne d'alimentation) de chacun des éléments de commande 124 locaux qui est reliée à la ligne GVGND 130.

La ligne GVGND 130 est couplée à un élément de commande général 132 qui, sur l'exemple de la figure 1, correspond à un inverseur formé par un transistor PMOS 134 et un transistor NMOS 136. Sur l'exemple de la figure 1, la sortie de cet inverseur, correspondant au point de liaison entre les drains des transistors 134 et 136, est reliée à la ligne GVGND 130. La source du transistor PMOS 134 forme une première borne d'alimentation électrique de l'élément de commande général 132 sur laquelle le potentiel électrique d'alimentation V_{DD} est appliqué. La source du transistor NMOS 136 forme une deuxième borne d'alimentation électrique de l'élément de commande général 132 sur laquelle le potentiel électrique de référence, correspondant à la masse GND dans ce premier mode de réalisation, est appliqué.

Ainsi, en fonction de la valeur du potentiel électrique appliqué sur l'entrée de l'élément de commande général 132 correspondant aux grilles des transistors 134, 136, l'élément de commande général 132 applique sur la ligne GVGND 130 un potentiel électrique égal au potentiel électrique d'alimentation V_{DD} ou au potentiel électrique de référence GND. L'élément de commande général 132 permet donc de choisir le potentiel électrique appliqué sur la ligne GVGND 130, et donc également la valeur du potentiel électrique appliqué sur la source des transistors NMOS 128 de chacun des éléments de commande locaux 124.

Lorsque la mémoire 100 est en mode veille, le circuit de contrôle 120 est configuré pour que l'élément de commande général 132 et les éléments de commande locaux 124 délivrent sur la ligne GVGND 130 et sur les lignes LVGND 122 un potentiel électrique sensiblement égal au potentiel électrique de pré-charge appliqué sur les lignes de bit 110, qui correspond ici au potentiel électrique d'alimentation V_{DD} de la mémoire 100.

Ainsi, dans ce mode veille, du fait que les lignes LVGND 122 sont au même potentiel électrique que les lignes de bit 110, les transistors des ports de lecture 104 sont soumis à une différence de potentiels électriques sensiblement nulle entre la deuxième électrode du transistor MOS 106 et la deuxième électrode du transistor MOS 108, ce qui empêche la génération de courants de fuite sous le seuil dans les ports de lecture 104.

De plus, dans ce mode veille, du fait que la ligne GVGND 130 est au même potentiel électrique que le potentiel électrique d'alimentation V_{DD} appliqué sur les sources des transistors PMOS 126 des éléments de commande locaux 124, ces transistors 126, 128 sont soumis, entre la source du transistor PMOS 126 et la source du transistor NMOS 128, à une différence de potentiels électriques sensiblement nulle, empêchant également la génération de courants de fuite sous le seuil dans les éléments de commande locaux 124.

Dans la mémoire 100, le seul courant de fuite sous le seuil généré dans le mode veille provient donc du transistor NMOS 136 de l'élément de commande général 132, ce qui représente, en considérant tous les transistors de la mémoire 100, une baisse importante de ces courants de fuite sous le seuil par rapport à la configuration où chacun des éléments de commande locaux 124 est relié directement à la masse et où un courant de fuite sous le seuil est donc généré dans chacun des éléments de commande locaux 124 lorsque la mémoire 100 est en mode veille.

En outre, dans le mode veille, du fait que les transistors 126, 128 de chacun des éléments de commande locaux 124 sont soumis, entre la source du transistor PMOS 126 et la source du transistor NMOS 128, à une différence de potentiels électriques sensiblement nulle, et donc que la tension V_{DS} aux bornes des transistors 126, 128 est nulle, il est possible de supprimer les courants de fuite de grille des transistors 126, 128 des éléments de commande locaux 124 en appliquant en entrée des éléments de commande locaux 124, c'est-à-dire sur les grilles des transistors 126, 128, un potentiel électrique de valeur sensiblement égale à celui appliqué sur les sources des transistors 126, 128, c'est-à-dire V_{DD}. Dans ce cas, du fait que les transistors 126, 128 des éléments de commande locaux 124 sont soumis, entre la source et la grille du transistor PMOS 126, et entre la source et la grille du transistor NMOS 128, à une différence de potentiels électriques sensiblement nulle, aucun courant de fuite de grille n'est généré dans les transistors 126, 128 des éléments de commande locaux 124.

Lorsque la mémoire 100 est en mode veille, le seul courant de fuite de grille généré provient donc des transistors NMOS et PMOS de l'élément de commande général 132, ce qui représente, en considérant tous les transistors de la mémoire 100, une baisse importante de ces courants de fuite de grille par rapport à la configuration où chacun des éléments de commande locaux 124 est relié directement à la masse et où des courants de fuite de grille sont donc générés dans chacun des transistors des éléments de commande locaux 124 lorsque la mémoire 100 est en mode veille, du fait qu'un potentiel électrique sensiblement nul doit être nécessairement appliqué sur les grilles de ces transistors pour obtenir sur les lignes VGND un potentiel électrique de valeur similaire à celle du potentiel électrique d'alimentation.

Lors de la lecture d'une des lignes de cellules mémoires 102, *M* courants de lecture, provenant des *M* cellules mémoires 102 de la ligne lue, transitent par la ligne LVGND 122 à laquelle sont couplées les cellules mémoires 102 de la ligne lue, puis par la ligne GVGND 130. Lors de cette lecture, l'élément de commande local 124 qui est couplé à cette ligne LVGND 122 et l'élément de commande général 132 peuvent polariser cette ligne LVGND 122 et la ligne GVGND 130 à un potentiel électrique correspondant au potentiel électrique de référence qui correspond à la masse GND dans ce premier mode de réalisation (via l'application d'un potentiel électrique équivalent au potentiel V_{DD} sur leur grille).

Pour les lignes de cellules mémoires 102 non lues, les potentiels électriques appliqués sur les lignes LVGND 122 qui sont couplées aux ports de lecture 104 associés aux cellules 102 de ces lignes ont une valeur sensiblement similaire à celle du potentiel électrique de pré-charge appliqué sur les lignes de bit 110. Il n'y a donc pas différence de potentiels entre les lignes de bit 110 et ces lignes LVGND 122 auxquelles les ports de lecture 104 des cellules 102 des lignes non lues sont couplés, et donc pas de courant de fuite sous le seuil des transistors 106, 108 de ces ports de lecture 104.

Les canaux des transistors 128 des éléments de commande locaux 124 sont dimensionnés avec une largeur *W* permettant le passage des courants de lecture de toutes les cellules mémoires 102 d'une ligne de la matrice de cellules mémoires 102, c'est-à-dire pour permettre le passage simultané de *M* courants de lecture.

Afin de minimiser le courant de fuite sous le seuil généré dans le transistor 136 de l'élément de commande général 132 lorsque la mémoire 100 est en mode veille, les transistors 134, 136 de l'élément de commande général 132 comportent avantageusement une tension de seuil importante et correspondent à des transistors de type HVT, ou « *High Voltage Threshold* » ou RVT, ou « *Regular Voltage Threshold* ». Cette tension de seuil importante, par exemple comprise entre environ 300 mV et 400 mV en technologie 28 nm, permet d'avoir une faible consommation statique, et donc un faible courant I_{OFF}, de ces transistors 134, 136. Par contre, cette importante tension de seuil a également pour conséquence de réduire le courant I_{ON} des transistors 134, 136. Cette baisse du courant I_{ON} est toutefois compensée par le fait que la largeur *W* des transistors 134, 136 de l'élément de commande général 132 est importante.

En outre, du fait que les courants de fuite sous le seuil ont été supprimés des éléments de commande locaux 124 lorsque la mémoire 100 est en mode veille, il n'est pas judicieux d'avoir des transistors 126, 128 des éléments de commande locaux 124 de type HVT ou RVT. De manière avantageuse, les transistors 126, 128 comportent une faible tension de seuil, par exemple de l'ordre de 300 mV, et sont de type LVT, ou « *Low Voltage Threshold* », ou plus généralement comportent une tension de seuil de valeur inférieure à celle de la tension de seuil des transistors 134, 136 de l'élément de commande général 132. Ainsi, les éléments de commande locaux 124 conservent une vitesse de fonctionnement importante.

Lors du fonctionnement de la mémoire 100, la vitesse de fonctionnement moins importante de l'élément de commande général 132 (du fait de la tension de seuil importante des transistors 134, 136 de l'élément de commande général 132) peut être compensée en activant par avance cet élément de commande général 132, c'est-à-dire en appliquant un potentiel électrique de commande sur l'entrée de l'élément de commande général 132 avant ceux appliqués sur les entrées des éléments de commande locaux 124.

Lorsque les transistors utilisés dans la mémoire 100 sont de type FDSOI, il est possible de modifier la valeur de la tension de seuil de ces transistors en modifiant la tension de polarisation appliquée sur la grille arrière de ces transistors. Cette possibilité de polarisation par la face arrière des transistors est avantageuse notamment pour les transistors 106, 108 des ports de lecture 104.

Dans le premier mode de réalisation décrit ci-dessus, les éléments de commande locaux 124 sont réalisés dans le décodeur d'adresse 114 et l'élément de commande général 132 est réalisé dans le circuit de contrôle 120. En variante, il est possible que les éléments de commande locaux 124 et/ou l'élément de commande général 132 soient réalisés dans une ou plusieurs parties de la mémoire 100 différentes du décodeur d'adresse 114 et/ou du circuit de contrôle 120.

De plus, dans le premier mode de réalisation décrit ci-dessus, chaque ligne de cellules mémoires 102 est associée à une ligne LVGND 122 qui lui est propre. La mémoire 100 comporte donc *N* lignes LVGND 122. En variante, il est possible que la mémoire 100 comporte *N*/2 ou (N/2)+1 lignes LVGND 122 (*N*/2 lorsque *N* est pair, et (*N*/2)+1 lorsque *N* est impair), chacune couplée aux ports de lecture 104 appartenant à deux lignes consécutives de cellules mémoires 102. Dans cette variante, la mémoire 100 comporte donc *N*/2 ou (*N*/2)+1 éléments de commande locaux 124 chacun couplé à l'une des lignes LVGND 122.

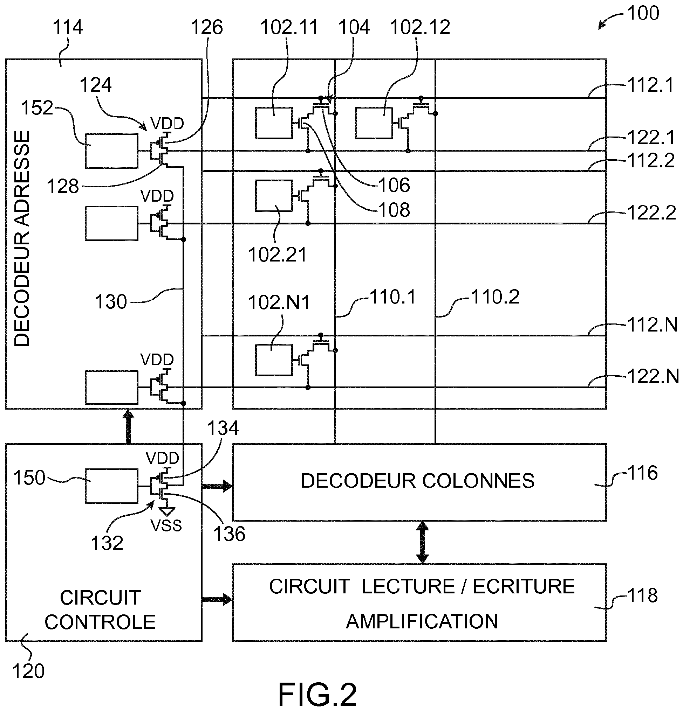

Une mémoire SRAM 100 selon un deuxième mode de réalisation est décrite ci-dessous en lien avec la figure 2.

La mémoire 100 selon ce deuxième mode de réalisation comprend tous les éléments de la mémoire 100 selon le premier mode de réalisation précédemment décrit.

Toutefois, à la différence du premier mode de réalisation, le potentiel électrique de référence ne correspond pas à la masse GND mais à un potentiel électrique négatif appelé Vss. Ainsi, le potentiel électrique appliqué sur la ligne GVGND 130 et les lignes LVGND 122 est égal au potentiel électrique d'alimentation V_{DD} ou au potentiel électrique négatif Vss, qui est par exemple égal à -V_{DD}. Pour pouvoir appliquer l'un ou l'autre de ces potentiels sur l'entrée de l'élément de commande général 132, c'est-à-dire sur les grilles des transistors 134, 136, la mémoire 100 comporte par exemple un circuit 150 de décalage de niveau, ou « level shifter », recevant en entrée un potentiel électrique de valeur égale à 0 ou VDD, et délivrant en sortie un potentiel électrique de valeur égale à Vss (lorsque le potentiel électrique d'entrée est égal à 0) ou à V_{DD} (lorsque le potentiel électrique d'entrée est égale à V_{DD}). La sortie de ce circuit 150 est couplée à l'entrée de l'élément de commande général 132. De plus, le potentiel électrique négatif Vss est également appliqué sur la borne d'alimentation de l'élément de commande général 132 destinée à recevoir le potentiel électrique de référence, c'est-à-dire la source du transistor NMOS 136.

La mémoire 100 selon ce deuxième mode de réalisation comporte également N circuits 152 de décalage de niveau, chacun similaire au circuit 150 et dont la sortie est couplée à l'entrée de l'un des éléments de commande locaux 124.

En mode veille, le fonctionnement de la mémoire 100 selon ce deuxième mode de réalisation est similaire à celui précédemment décrit pour la mémoire 100 selon le premier mode de réalisation.

Lors de la lecture ou de l'écriture dans une des lignes de la mémoire 100 selon ce deuxième mode de réalisation, l'élément de commande local 124 qui est couplé à la ligne LVGND 122 associée à la ligne de cellules mémoires 102 lues et l'élément de commande général 132 polarisent cette ligne LVGND 122 et la ligne GVGND 130 au potentiel électrique Vss. Un potentiel électrique de valeur égale à V_{DD} est donc appliqué en entrée de l'élément de commande général 132 et en entrée de l'élément de commande locale 124 associé à la ligne lue. Ainsi, une décharge de courant plus importante est obtenue depuis les lignes de bit 110 et à travers les ports de lecture 104 des cellules mémoires 102 lues et les lignes LVGND 122 et GVGND 130 qui sont couplées au potentiel électrique Vss à travers l'élément de commande local 124 associé à la ligne de cellules mémoires 102 lues et à travers l'élément de commande général 132. Cette décharge de courant est donc plus rapide que lorsque l'élément de commande général 132 et l'élément de commande local 124 appliquent un potentiel GND sur les lignes GVGND 130 et LVGND 122, augmentant ainsi la vitesse de fonctionnement de la mémoire 100.

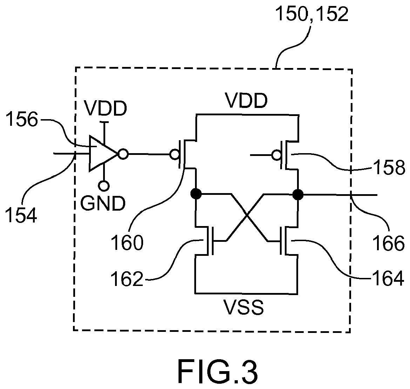

Un exemple de réalisation du circuit 150 (ou d'un des circuits 152 qui peuvent être similaires au circuit 150) est représenté sur la figure 3.

Le circuit 150 comporte une entrée 154 sur laquelle est appliqué le signal d'entrée. Ce signal d'entrée est envoyé à l'entrée d'un inverseur 156 et sur la grille d'un transistor PMOS 158. La sortie de l'inverseur 156 est reliée à la grille d'un autre transistor PMOS 160. Les sources des transistors PMOS 158, 160 sont reliées au potentiel électrique V_{DD}. Le drain du transistor PMOS 158 est relié à la grille d'un transistor NMOS 162 et au drain d'un autre transistor NMOS 164. Le drain du transistor PMOS 160 est relié à la grille du transistor NMOS 164 et au drain du transistor NMOS 162. Les sources des transistors NMOS 162, 164 sont reliés au potentiel électrique Vss. Une sortie 166 du circuit 150 est obtenue au point de liaison entre la grille du transistor NMOS 162 et les drains du transistor PMOS 158 et du transistor NMOS 164.

Avec un tel circuit 150, le signal obtenu sur la sortie 166 a pour valeur V_{DD} ou Vss selon que le signal d'entrée a pour valeur V_{DD} ou GND.

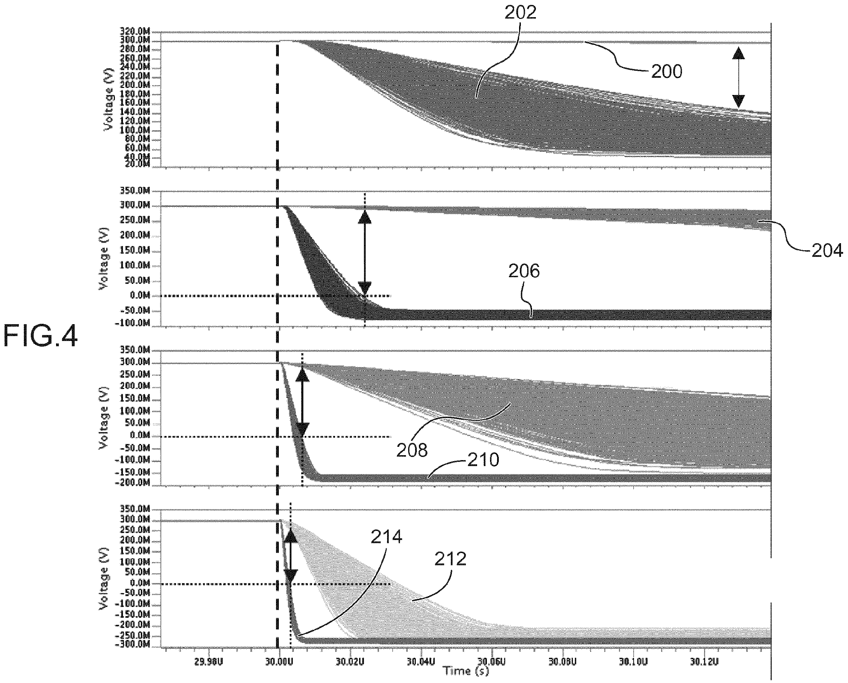

La figure 4 représente, pour différentes valeurs de Vss, la décharge du potentiel électrique sur une des lignes de bit 110, lors de la lecture d'une cellule mémoire 102 de la mémoire 100. Ces résultats ont été obtenus en utilisant un potentiel électrique d'alimentation V_{DD} = 0,3 V qui correspond au potentiel électrique de pré-charge de la ligne de bit 110. La référence 200 désigne la décharge du potentiel dans la ligne de bit 110 lors de la lecture d'un bit '0' (correspondant à un potentiel GND) stocké dans la cellule mémoire 102 lue, et la référence 202 désigne la décharge du potentiel dans la ligne de bit 110 lors de la lecture d'un bit '1' (correspondant à un potentiel V_{DD}) stocké dans la cellule mémoire 102, lorsque la mémoire 100 est réalisée selon le premier mode de réalisation, c'est-à-dire lorsque le potentiel électrique Vss négatif n'est pas utilisé.

La référence 204 désigne la décharge du potentiel dans la ligne de bit 110 lors de la lecture d'un bit '0', et la référence 206 désigne la décharge du potentiel dans la ligne de bit 110 lors de la lecture d'un bit '1', lorsque la mémoire 100 est réalisée selon le deuxième mode de réalisation avec Vss = -0,1 V. La référence 208 désigne la décharge du potentiel dans la ligne de bit 110 lors de la lecture d'un bit '0', et la référence 210 désigne la décharge du potentiel dans la ligne de bit 110 lors de la lecture d'un bit '1', avec Vss = -0,2 V. Enfin, La référence 212 désigne la décharge du potentiel dans la ligne de bit 110 lors de la lecture d'un bit '0', et la référence 214 désigne la décharge du potentiel dans la ligne de bit 110 lors de la lecture d'un bit '1', avec Vss = -0,3 V.

Les flèches visibles sur la figure 4 représentent chacune l'instant à partir duquel un écart suffisant est obtenu pour discriminer la valeur du bit lu. Ainsi, il apparait clairement que l'utilisation d'un potentiel électrique de référence Vss de valeur négative appliquée sur les lignes GVGND 130 et LVGND 122 lors de la lecture permet de réduire de manière importante le temps de décharge du potentiel de la ligne de bit 110 lors de la lecture d'un bit '1', tout en maintenant, lors de la lecture d'un bit '0', un potentiel électrique proche de V_{DD} pendant une durée suffisante pour discriminer la valeur du bit lu.

Il convient de noter également que la liaison des transistors 128 des éléments de commande locaux 124 à la ligne GVGND 130 et à l'élément de commande global 132 permet à la mémoire 100 de fonctionner correctement, même à une température élevée, par exemple de l'ordre de 125°C.

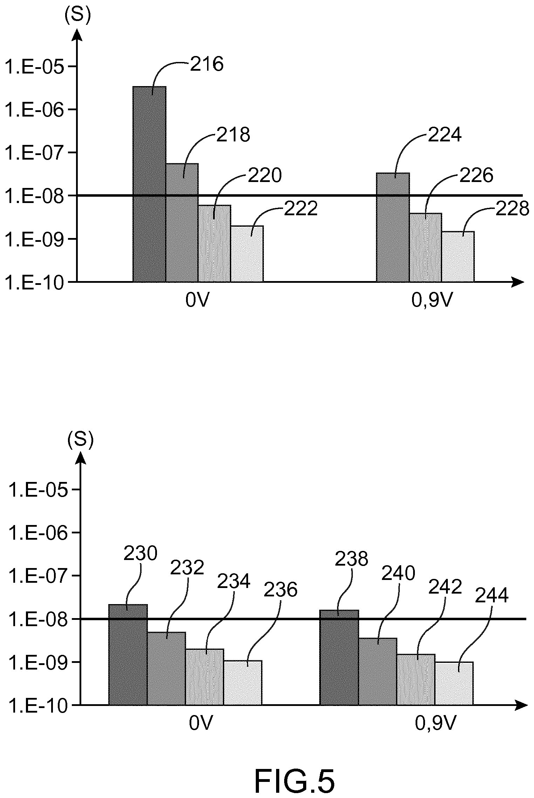

L'histogramme visible sur la figure 5 représente la durée pour obtenir une baisse de 50 mV du potentiel électrique de la ligne de bit 110, lors d'une lecture dans la mémoire 100, avec un potentiel électrique d'alimentation V_{DD} = 0,3 V et pour différentes valeurs du potentiel appliqué sur les LVGND 122 et la GVGND 130. La référence 216 représente cette durée de décharge pour la mémoire 100 selon le premier mode de réalisation, et les références 218, 220 et 222 représentent cette durée de décharge pour la mémoire 100 selon le deuxième mode de réalisation avec le potentiel électrique de référence Vss respectivement égal à -0,1 V, -0,2 V et -0,3 V, à une température de -40°C. Les références 224, 226 et 228 représentent cette durée de décharge pour la mémoire 100 selon le deuxième mode de réalisation avec le potentiel électrique de référence Vss respectivement égal à -0,1 V, -0,2 V et -0,3 V, et avec une polarisation en face arrière de 0,9 V appliquée sur les transistors 106, 108 des ports de lecture 104, également à une température de -40°C. La référence 230 représente cette durée de décharge pour la mémoire 100 selon le premier mode de réalisation, et les références 232, 234 et 236 représentent cette durée de décharge pour la mémoire 100 selon le deuxième mode de réalisation avec le potentiel électrique de référence Vss respectivement égal à -0,1 V, -0,2 V et -0,3 V, à une température de 125°C. La référence 238 représente cette durée de décharge pour la mémoire 100 selon le premier mode de réalisation, et avec une polarisation en face arrière de 0,9 V appliquée sur les transistors 106, 108 des ports de lecture 104, également à une température de 125°C. Les références 240, 242 et 244 représentent cette durée de décharge pour la mémoire 100 selon le deuxième mode de réalisation avec le potentiel électrique de référence Vss respectivement égal à -0,1 V, -0,2 V et -0,3 V, et avec une polarisation en face arrière de 0,9 V appliquée sur les transistors 106, 108 des ports de lecture 104, également à une température de 125°C.

Le tableau ci-dessous récapitule les courants de fuite obtenus dans les ports de lecture 104 d'une mémoire 100 comprenant une matrice de 1024 lignes et 32 colonnes de cellules mémoires 102, en mode veille, selon différentes configurations :

| | Nb cellules | Ref (nW) | 1^{er} mode (nW) | 2^{ème} mode (nW) |
|---|---|---|---|---|
| RVT | 1024 | 303 | 0,108 | 0,037 |
| RVT | 1 | 0,2958984 | 1,05469E-4 | 3,61328E-5 |
| RVT | 32768 | 9636 | 3,456 | 1,184 |
| LVT sans FBB | 1024 | 1000 | 0,802 | |
| LVT sans FBB | 1 | 0,9765625 | 7,83203E-4 | 2,75391E-4 |
| LVT sans FBB | 32768 | 32000 | 25,664 | 9,024 |
| LVT avec FBB | 1024 | 1920 | 0,816 | 0,283 |
| LVT avec FBB | 1 | 1,875 | 7,96875E-4 | 2,76367E-4 |
| LVT avec FBB | 32768 | 61440 | 26,112 | 9,056 |

Dans le tableau ci-dessus, les lignes « RVT » correspondent aux configurations où les transistors des ports de lecture 104 et des éléments de commande locaux 124 sont de type RVT. Les lignes « LVT sans FBB » correspondent aux configurations où les transistors des ports de lecture 104 et des éléments de commande locaux 124 sont de type LVT sans polarisation de leur face arrière. Les lignes « LVT avec FBB » correspondent aux configurations où les transistors des ports de lecture 104 et des éléments de commande locaux 124 sont de type LVT avec une polarisation de leur face arrière. La colonne « Ref » correspond aux fuites obtenues dans une mémoire dans laquelle l'élément de commande général 132 et la ligne GVGND 130 sont absents, les sources des transistors 128 des éléments de commande locaux 124 étant reliées à la masse. La colonne « 1^{er} mode » correspond aux fuites obtenues dans la mémoire 100 selon le premier mode de réalisation, et la colonne « 2^{ème} mode » correspond aux fuites obtenues dans la mémoire 100 selon le deuxième mode de réalisation.

Le tableau ci-dessous récapitule les courants de fuite obtenus dans les éléments de commande locaux 124 et généraux 130, en mode veille, selon différentes configurations :

| | Nb cellules | Ref (nW) | 1^{er} mode (nW) | 2^{ème} mode (nW) |
|---|---|---|---|---|
| RVT | 1024 | 730 | 1,05 | 0,66 |
| LVT sans FBB | 1024 | 2252 | 4,67 | 2,03 |
| LVT avec FBB | 1024 | 4130 | 6,52 | 2,71 |

Le tableau ci-dessous récapitule les courants de fuite obtenus dans l'ensemble de la mémoire 100, en mode veille, selon différentes configurations :

| | Ref (nW) | 1^{er} mode (nW) | 2^{ème} mode (nW) |
|---|---|---|---|
| RVT | 10426 | 4,506 | 1,844 |
| LVT sans FBB | 34252 | 30,334 | 11,054 |
| LVT avec FBB | 65570 | 32,632 | 11,766 |

Ces tableaux montrent clairement la forte réduction des courants de fuite obtenue en mettant en oeuvre l'invention quel que soit son mode de réalisation.

Dans les exemples de réalisation précédemment décrits, l'élément de commande général 132 comporte un transistor PMOS 134 couplé à un transistor NMOS 136. En variante, il est possible que l'élément de commande général 132 comporte un élément de blocage de puissance (« power gate » en anglais) permettant, lorsque la mémoire 100 est en mode veille, de réduire le courant de fuite généré depuis le transistor NMOS 136. Cet élément de blocage de puissance est par exemple interposé entre le potentiel électrique de référence (correspondant à la masse ou au potentiel électrique négatif Vss) et le transistor NMOS 136. Cet élément de blocage de puissance correspond par exemple à un transistor NMOS supplémentaire comprenant sa grille reliée à la grille du transistor NMOS 136, son drain relié à la source du transistor NMOS 136 (la source du transistor NMOS 136 n'étant plus reliée directement au potentiel électrique de référence), et sa source reliée au potentiel électrique de référence.

## Revendications

1. Mémoire SRAM (100) comportant au moins :
- une matrice de cellules mémoires (102) formant des colonnes et des lignes de cellules mémoires (102) ;
- des lignes de bit (110) chacune associée à une des colonnes de cellules mémoires (102), et des lignes de mot (112) chacune associée à une des lignes de cellules mémoires (102) ;
- des ports de lecture (104) chacun associé à l'une des cellules mémoires (102) et couplé à une des lignes de bit (110) et une des lignes de mot (112) ;
- des lignes de masse virtuelle locale (122), appelées lignes LVGND chacune couplée à des bornes de potentiel de référence des ports de lecture (104) d'au moins une des lignes de cellules mémoires (104) ;
- des éléments de commande locaux (124) chacun configuré pour coupler électriquement l'une des lignes LVGND (122) à un potentiel électrique d'alimentation appliqué sur une premier borne d'alimentation des éléments de commande locaux (124) ou à une ligne de masse virtuelle générale (130), ou ligne GVGND, à laquelle une deuxième borne d'alimentation des éléments de commande locaux (124) est couplée ;
- un élément de commande général (132) configuré pour coupler la ligne GVGND (130) au potentiel électrique d'alimentation ou à un potentiel électrique de référence ;
et dans leaguelle l'élément de commande général (132) comporte au moins un inverseur comprenant au moins un deuxième transistor PMOS (134) et un deuxième transistor NMOS (136) configurés tels que :
- la source du deuxième transistor PMOS (134) est couplée au potentiel électrique d'alimentation,
- la source du deuxiéme transistor NMOS (136) est couplée au potentiel électrique de référence,
- les drains des deuxièmes transistors PMOS et NMOS (134, 136), formant une sortie de l'élément de commande général (132), sont couplés à la ligne GVGND (130),
- une entrée de commande de l'élément de commande général (132) est couplée aux grilles des deuxièmes transistors NMOS et PMOS (134, 136) de l'élément de commande général (132).

2. Mémoire SRAM (100) selon la revendication 1, dans lequel le potentiel électrique de référence correspond à la masse et a une valeur sensiblement nulle, ou dans lequel le potentiel électrique de référence a une valeur négative.

3. Mémoire SRAM (100) selon l'une des revendications précédentes, dans lequel chacun des éléments de commande locaux (124) comporte au moins un inverseur comprenant au moins un premier transistor PMOS (126) et un premier transistor NMOS (128) configurés tels que :
- la source du premier transistor PMOS (126) est couplée au potentiel électrique d'alimentation,
- la source du premier transistor NMOS (128) est couplée à la ligne GVGND (130),
- les drains des premiers transistors PMOS et NMOS (126, 128), formant une sortie de l'inverseur de l'élément de commande local (124), sont couplés à la ligne LVGND (122) associée à l'élément de commande local (124),
- une entrée de commande de chacun des éléments de commande locaux (124) est couplée aux grilles des premiers transistors NMOS et PMOS (126, 128) de l'élément de commande local (124).

4. Mémoire SRAM (100) selon la revendication 3, comportant en outre des circuits (150, 152) chacun configuré pour appliquer un potentiel électrique de valeur sensiblement égale au potentiel électrique d'alimentation ou au potentiel électrique de référence sur l'entrée de commande d'un des éléments de commande locaux (124) ou de l'élément de commande général (132).

5. Mémoire SRAM (100) selon la revendication 4, dans lequel chacun des circuits (150, 152) couplés aux entrées de commande des éléments de commande locaux (124) et de l'élément de commande général (132) correspond à un circuit de décalage de niveau configuré pour délivrer en sortie un potentiel électrique de valeur sensiblement égale à celle du potentiel électrique d'alimentation ou de valeur négative.

6. Mémoire SRAM (100) selon l'une des revendications précédentes, dans laquelle, dans un mode veille, la mémoire SRAM (100) est configurée telle que :
- un potentiel électrique de pré-charge sensiblement égal au potentiel électrique d'alimentation est appliqué sur les lignes de bit (110),
- les éléments de commande locaux (124) couplent électriquement les lignes LVGND (122) au potentiel électrique d'alimentation, et
- l'élément de commande général (132) couple la ligne GVGND (130) au potentiel électrique d'alimentation.

7. Mémoire SRAM (100) selon les revendications 4 et 6, dans laquelle, dans le mode veille, les circuits (152) couplés aux entrées de commande des éléments de commande locaux (124) sont configurés pour appliquer le potentiel électrique d'alimentation sur les entrées de commande des éléments de commande locaux (124).

8. Mémoire SRAM (100) selon l'une des revendications précédentes, dans lequel, lorsque les éléments de commande locaux (124) et l'élément de commande général (132) comportent chacun des transistors MOS (126, 128, 134, 136), les transistors MOS (134, 136) de l'élément de commande général (132) comportent une tension de seuil supérieure à celle des transistors MOS (126, 128) des éléments de commande locaux (124).

9. Mémoire SRAM (100) selon l'une des revendications précédentes, dans lequel, lors d'une lecture d'une des lignes de cellules mémoires (102), la mémoire SRAM (100) est configurée telle que :
- l'un des éléments de commande locaux (124) couple la ligne LVGND (122) qui est associée à la ligne de cellules mémoires (102) lue à la ligne GVGND (130),
- les autres éléments de commande locaux (124) couplent les autres lignes LVGND (122) au potentiel électrique d'alimentation,
- l'élément de commande général (132) couple la ligne GVGND (130) au potentiel électrique de référence.

10. Mémoire SRAM (100) selon l'une des revendications précédentes, dans lequel les éléments de commande locaux (124) font partie d'un décodeur d'adresse (114) de la mémoire SRAM (100), et dans lequel l'élément de commande général (132) fait partie d'un circuit de contrôle (120) de la mémoire SRAM (100) apte à envoyer des signaux de commande au décodeur d'adresse (114).

11. Mémoire SRAM (100) selon l'une des revendications précédentes, dans lequel chaque ligne LVGND (122) est couplée aux bornes de potentiel de référence des ports de lecture (104) de deux lignes successives de cellules mémoires (102).

## Patentansprüche

1. SRAM-Speicher (100), der mindestens aufweist:
- ein Feld aus Speicherzellen (102), das Spalten und Reihen von Speicherzellen (102) bilden;
- Bit-Reihen (110), die jeweils einer der Spalten von Speicherzellen (102) zugeordnet sind, und Wort-Reihen (112), die jeweils einer der Reihen von Speicherzellen (102) zugeordnet sind;
- Leseports (104), die jeweils einer der Speicherzellen (102) zugeordnet und an eine der Bit-Reihen (110) und eine der Wort-Reihen (112) gekoppelt sind;
- lokale Scheinmasseleitungen (122), bezeichnet als LVGND-Leitungen, die jeweils an Referenzpotentialanschlüsse der Leseports (104) mindestens einer der Reihen von Speicherzellen (104) gekoppelt sind;
- lokale Steuerelemente (124), die jeweils ausgelegt sind, um eine der LVGND-Leitungen (122) mit einem elektrischen Versorgungspotential elektrisch zu koppeln, das an einem ersten Versorgungsanschluss der lokalen Steuerelemente (124) anliegt, oder mit einer allgemeinen Scheinmasseleitung (130) oder GVGND-Leitung, an die ein zweiter Versorgungsanschluss der lokalen Steuerelemente (124) gekoppelt ist;
- ein allgemeines Steuerelement (132), das ausgelegt ist, um die GVGND-Leitung (130) an das elektrische Versorgungspotential oder an ein elektrisches Referenzpotential zu koppeln;
und wobei das allgemeine Steuerelement (132) mindestens einen Wechselrichter aufweist, der mindestens einen zweiten PMOS-Transistor (134) und einen zweiten NMOS-Transistor (136) umfasst, die derart ausgelegt sind, dass:
- die Quelle des zweiten PMOS-Transistors (134) an das elektrische Versorgungspotential gekoppelt ist,
- die Quelle des zweiten NMOS-Transistors (136) an das elektrische Referenzpotential gekoppelt ist,
- die Drains des zweiten PMOS- und NMOS-Transistors (134, 136), die einen Ausgang des allgemeinen Steuerelements (132) bilden, an die GVGND-Leitung (130) gekoppelt sind,
- ein Steuereingang des allgemeinen Steuerelements (132) an die Gitter des zweiten NMOS- und PMOS- Transistors (134, 136) des allgemeinen Steuerelements (132) gekoppelt ist.

2. SRAM-Speicher (100) nach Anspruch 1, wobei das elektrische Referenzpotential der Masse entspricht und einen Wert von etwa null hat oder wobei das elektrische Referenzpotential einen negativen Wert hat.

3. SRAM-Speicher (100) nach einem der vorangehenden Ansprüche, wobei jedes der lokalen Steuerelemente (124) mindestens einen Wechselrichter aufweist, der mindestens einen ersten PMOS-Transistor (126) und einen ersten NMOS-Transistor (128) umfasst, die derart ausgelegt sind, dass:
- die Quelle des ersten PMOS-Transistors (126) an das elektrische Versorgungspotential gekoppelt ist,
- die Quelle des ersten NMOS-Transistors (128) an die GVGND-Leitung (130) gekoppelt ist,
- die Drains des ersten PMOS- und NMOS-Transistors (126, 128), die einen Ausgang des Wechselrichters des lokalen Steuerelements (124) bilden, an die LVGND-Leitung (122) gekoppelt sind, die dem lokalen Steuerelement (124) zugeordnet ist,
- ein Steuereingang von jedem der lokalen Steuerelemente (124) an die Gitter des ersten NMOS- und PMOS- Transistors (126, 128) des lokalen Steuerelements (124) gekoppelt ist.

4. SRAM-Speicher (100) nach Anspruch 3, der ferner Schaltungen (150, 152) aufweist, die jeweils ausgelegt sind, um ein elektrisches Potential mit einem Wert anzulegen, der etwa gleich dem elektrischen Versorgungspotential oder dem elektrischen Referenzpotential am Steuereingang eines der lokalen Steuerelemente (124) oder des allgemeinen Steuerelements (132) ist.

5. SRAM-Speicher (100) nach Anspruch 4, wobei jede der Schaltungen (150, 152), die an die Steuereingänge der lokalen Steuerelemente (124) und des allgemeinen Steuerelements (132) gekoppelt sind, einer Pegelverschiebeschaltung entspricht, die ausgelegt ist, um am Ausgang ein elektrisches Potential mit einem Wert bereitzustellen, der etwa gleich dem des elektrischen Versorgungspotentials ist oder mit einem negativen Wert.

6. SRAM-Speicher (100) nach einem der vorangehenden Ansprüche, wobei in einem Bereitschaftsmodus der SRAM-Speicher (100) derart ausgelegt ist, dass:
- ein elektrisches Vorlastpotential, das etwa gleich dem elektrischen Versorgungspotential ist, auf die Bit-Reihen (110) angewendet wird,
- die lokalen Steuerelemente (124) die LVGND-Leitungen (122) mit dem elektrischen Versorgungspotential elektrisch koppeln, und
- das allgemeine Steuerelement (132) die GVGND-Leitung (130) mit dem elektrischen Versorgungspotential koppelt.

7. SRAM-Speicher (100) nach den Ansprüchen 4 und 6, wobei im Bereitschaftsmodus die Schaltungen (152), die an die Steuereingänge der lokalen Steuerelemente (124) gekoppelt sind, ausgelegt sind, um das elektrische Versorgungspotential an die Steuereingänge der lokalen Steuerelemente (124) anzulegen.

8. SRAM-Speicher (100) nach einem der vorangehenden Ansprüche, wobei, wenn die lokalen Steuerelemente (124) und das allgemeine Steuerelement (132) jeweils MOS-Transistoren (126, 128, 134, 136) aufweisen, die MOS-Transistoren (134, 136) des allgemeinen Steuerelements (132) eine Schwellenspannung aufweisen, die höher als die der MOS-Transistoren (126, 128) der lokalen Steuerelemente (124) ist.

9. SRAM-Speicher (100) nach einem der vorangehenden Ansprüche, wobei bei einer Auslesung einer der Reihen von Speicherzellen (102) der SRAM-Speicher (100) derart ausgelegt ist, dass:
- eins der lokalen Steuerelemente (124) die LVGND-Leitung (122), die der der ausgelesenen Reihe von Speicherzellen (102) zugeordnet ist, an die GVGND-Leitung (130) koppelt,
- die anderen lokalen Steuerelemente (124) die anderen LVGND-Leitungen (122) an das elektrische Versorgungspotential koppeln,
- das allgemeine Steuerelement (132) die GVGND-Leitung (130) an das elektrische Referenzpotential koppelt.

10. SRAM-Speicher (100) nach einem der vorangehenden Ansprüche, wobei die lokalen Steuerelemente (124) Teil eines Adressdecoders (114) des SRAM-Speichers (100) sind und wobei das allgemeine Steuerelement (132) Teil einer Kontrollschaltung (120) des SRAM-Speichers (100) ist, die imstande ist, Steuersignale an den Adressdecoder (114) zu senden.

11. SRAM-Speicher (100) nach einem der vorangehenden Ansprüche, wobei jede LVGND-Leitung (122) an die Referenzpotentialanschlüsse der Leseports (104) von zwei aufeinanderfolgenden Reihen von Speicherzellen (102) gekoppelt ist.

## Claims

1. SRAM memory (100) including at least:
- one matrix of memory cells (102) forming columns and rows of memory cells (102);
- bit lines (110) each associated with one of the columns of memory cells (102), and word lines (112) each associated to one of the rows of memory cells (102);
- read ports (104) each associated with one of the memory cells (102) and coupled to one of the bit lines (110) and one of the word lines (112);
- local virtual ground lines (122), named LVGND lines, each coupled to the reference potential terminals of the read ports (104) of at least one of the rows of memory cells (104);
- local control elements (124) each configured to electrically couple one of the LVGND lines (122) to a power supply electric potential applied on a first power supply terminal of the local control elements (124) or to a global virtual ground line (130), or GVGND line, to which a second power supply terminal of the local control elements (124) is coupled;
- one global control element (132) configured to couple the GVGND line (130) to the power supply electric potential or to a reference electric potential;
wherein the global control element (132) includes at least one inverter comprising at least one second PMOS transistor (134) and one second NMOS transistor (136) configured such that:
- the source of the second PMOS transistor (134) is coupled to the power supply electric potential,
- the source of the second NMOS transistor (136) is coupled to the reference electric potential,
- the drains of the second PMOS and NMOS transistors (134, 136), forming an output of the global control element (132), are coupled to the GVGND line (130),
- a control input of the global control element (132) is coupled to gates of the second PMOS and NMOS transistors (134, 136) of the global control element (132).

2. SRAM memory (100) according to claim 1, wherein the reference electric potential corresponds to the ground and has a substantially zero value, or wherein the reference electric potential has a negative value.

3. SRAM memory (100) according to one of previous claims, wherein each of the local control elements (124) includes at least one inverter comprising at least one first PMOS transistor (126) and one first NMOS transistor (128) configured such that:
- the source of the first PMOS transistor (126) is coupled to the power supply electric potential,
- the source of the first NMOS transistor (128) is coupled to the GVGND line (130),
- the drains of the first PMOS and NMOS transistors (126, 128), forming an output of the inverter of the local control element (124), are coupled to the LVGND line (122) associated with the local control element (124),
- a control input of each of the local control elements (124) is coupled to gates of the first PMOS and NMOS transistors (126, 128) of the local control element (124).

4. SRAM memory (100) according to claim 3, further comprising circuits (150, 152) each configured to apply an electric potential of value substantially equal to the power supply electric potential or to the reference electric potential on the control input of one of the local control elements (124) or of the global control element (132).

5. SRAM memory (100) according to claim 4, wherein each of the circuits (150, 152) coupled to the control inputs of the local control elements (124) and of the global control element (132) corresponds to a level shifter circuit configured to output an electric potential of value substantially equal to same of the power supply electric potential or of negative value.

6. SRAM memory (100) according to one of previous claims, wherein, in a standby mode, the SRAM memory (100) is configured such that:
- a precharge electric potential substantially equal to the power supply electric potential is applied on the bit lines (110),
- the local control elements (124) electrically couple the LVGND lines (122) to the power supply electric potential, and
- the global control element (132) couples the GVGND line (130) to the power supply electric potential.

7. SRAM memory (100) according to claims 4 and 6, wherein, in the standby mode, the circuits (152) coupled to the control inputs of the local control elements (124) are configured to apply the power supply electric potential on the control inputs of the local control elements (124).

8. SRAM memory (100) according to one of previous claims, wherein, when the local control elements (124) and the global control element (132) each include MOS transistors (126, 128, 134, 136), the MOS transistors (134, 136) of the global control element (132) include a threshold voltage greater than same of the MOS transistors (126, 128) of the local control elements (124).

9. SRAM memory (100) according to one of previous claims, wherein, during a reading of one of the rows of memory cells (102), the SRAM memory (100) is configured such that:
- one of the local control elements (124) couples the LVGND line (122) that is associated with the row of the memory cells (102) read to the GVGND line (130),
- the other local control elements (124) couple the other LVGND lines (122) to the power supply electric potential,
- the global control element (132) couples the GVGND line (130) to the reference electric potential.

10. SRAM memory (100) according to one of previous claims, wherein the local control elements (124) form part of an address decoder (114) of the SRAM memory (100), and wherein the global control element (132) forms part of a control circuit (120) of the SRAM memory (100) suitable for sending control signals to the address decoder (114).

11. SRAM memory (100) according to one of the preceding claims, wherein each LVGND line (122) is coupled to the reference potential terminals of the read ports (104) of two successive rows of memory cells (102).
